# EUROPEAN PATENT APPLICATION

(11) **EP 0 525 718 A1**
(43) Date of publication of application: **03.02.1993**
(21) Application number: 92112855.9
(22) Date of filing: 28.07.1992
(51) Int. Cl.: B23K 1/08

(54) **Automatic soldering apparatus for printed wiring boards**

(30) Priority: 02.08.1991 JP 216400/91
(71) Applicant: CANON KABUSHIKI KAISHA, Tokyo (JP)
(72) Inventor: Ishiwata, Fumikazu, c/o Canon Kabushiki Kaisha, Ohta-ku, Tokyo (JP); Sugawara, Akira, c/o Canon Kabushiki Kaisha, Ohta-ku, Tokyo (JP)
(74) Representative: Blumbach Weser Bergen Kramer Zwirner Hoffmann Patentanwälte

(57) **Abstract**

In an automatic soldering apparatus adapted to transport a printed wiring board 1 by a transporting conveyer 2 from a fluxer 3 through a preheater 4 to a solder bath T, a spray pipe 5 having a multiplicity of nozzle holes is arranged between the fluxer 3 and the preheater 4. The nozzle holes of the spray pipe 5 are open in the direction opposite to a running direction of the printed wiring board 1. By blowing a gas such as air or inert gas from the nozzle holes onto the lower surface of the printed wiring board 1, part of a flux coated on the printed wiring board 1 is forced to penetrate into through holes in the printed wiring board 1, thereby improving the wettability of the through holes with respect to molten solder in the solder bath T.

## Description

### BACKGROUND OF THE INVENTION

### Field of the Invention

The present invention relates to an automatic soldering apparatus for printed wiring boards, and more particularly to an improved automatic soldering apparatus which can sufficiently fill melt solder in through holes formed in a printed wiring board.

### Related Background Art

An automatic soldering process is generally carried out in the following manner.

Electronic parts such as chip parts, lead parts and the like are first mounted on a printed wiring board, and tacked with a bonding agent and a temporary solder. Then, a flux is coated over the printed wiring board by a fluxer of flow-type, foaming-type or the like. Subsequently, the printed wiring board is transported through a preheater to a flow-type or dip-type solder bath. The flux is principally used to remove an oxide film on the surfaces of exposed conductors on the printed wiring board to improve the wettability of solder. However, since oxidation has begun on the surfaces of exposed conductors immediately after producing of the printed wiring board, the thickness of an oxide film is increased until a flux is coated, which makes it difficult to sufficiently coat the flux to perfectly remove the oxide film by a flow-type or foaming-type flux coating apparatus which is generally used in an automatic soldering process. Therefore, conventionally, a preflux is coated immediately after producing of the printed wiring board in order to prevent the surface thereof from being oxidized, so that exposed conductors are prevented from being oxidized before a flux is coated by a fluxer, that is, during mounting and tacking of parts on the printed wiring boards.

In the foregoing conventional method, however, since a printed wiring board is repeatedly heated in a step of melting the temporary solder for tacking parts and in a step of hardening the bonding agent, an oxidation preventing effect of the preflux for the exposed conductors is not sufficient. Particularly, an oxide film, if formed in through holes, will significantly damage the wettability of solder and prevent molten solder from sufficiently penetrating into such through holes, thereby causing soldering of lead parts to fail.

### SUMMARY OF THE INVENTION

The present invention has been made in view of the problems inherent in the conventional arts, and its object is to provide an automatic soldering apparatus for printed wiring boards which is adapted to blow a gas such as air, inert gas or the like onto a surface of a printed wiring board with a flux coated thereon by a fluxer to force the flux to penetrate into through holes and accordingly improve the wettability of the through holes with respect to solder.

To achieve the above object, an automatic soldering apparatus for printed wiring boards according to the present invention is characterized by comprising transporting means for successively transporting the printed wiring board having through holes to a solder bath; a fluxer for coating a flux on the printed wiring board; and means for blowing a gas onto a surface of the printed wiring board which has been coated with the flux by the fluxer.

Preferably, the means for blowing a gas is provided with a spray pipe with a multiplicity of nozzle holes which are aligned to intersect with a transporting direction of the printed wiring boards.

It is also preferable that the gas is a fire retardant gas and blows out in the direction opposite to the transporting direction of the printed wiring boards.

By blowing a gas onto a printed wiring board after having passed the fluxer, a part of flux adhered on the printed wiring board is forced to penetrate into through holes formed in the printed wiring board. By arranging the nozzle holes for blowing the gas so as to intersect with the transporting direction of the printed wiring board, the gas is blown onto the whole surface of the printed wiring board. Also, the use of the fire retardant gas enhances the safety. Particularly, the gas is blown out in the direction opposite to the transporting direction of the printed wiring boards so that gasified components of the flux is prevented from entering a preheater arranged at the entrance of a solder bath.

### BRIEF DESCRIPTION OF THE DRAWINGS

Fig. 1 is a partially elevational schematic diagram showing a main portion of an embodiment of the present invention;
Fig. 2 is an explanatory diagram showing a piping of a spray pipe; and
Fig. 3 is an elevational view of the spray pipe.

### DESCRIPTION OF THE PREFERRED EMBODIMENT

One embodiment of the present invention will hereinafter be described in connection with the accompanying drawings.

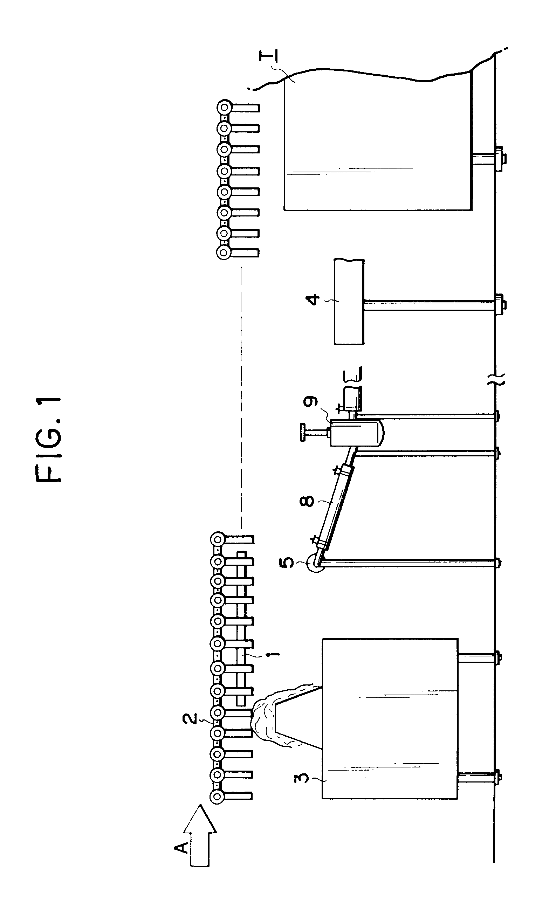

Fig. 1 is a partially elevational schematic diagram showing part of one embodiment of the present invention. A printed wiring board 1 on which parts have been mounted in a former step is transported in a direction as indicated in Fig. 1 by arrow A by a transporting conveyer 2 toward a flow-type or dip-type solder bath T through a fluxer 3 and a preheater 4. Incidentally, electronic parts mounted on the printed wiring board 1 are omitted in the drawing in order to avoid complexity.

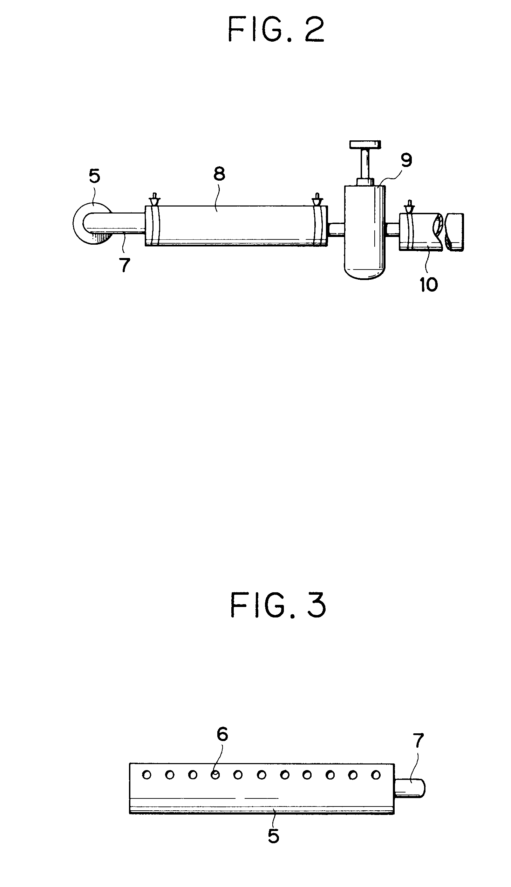

Between the fluxer 3 and the preheater 4, there is arranged one or a plurality of spray pipes 5 at a position adjacent to the fluxer 3. The spray pipe 5 has a multiplicity of nozzle holes 6 aligned in an axial direction, as shown in Fig. 3. The nozzle holes are arranged so as to open diagonally upwardly in a direction opposite to the printed wiring board 1 being transported above the spray pipe 5. The spray pipe 5 is arranged perpendicularly to a running direction of the printed wiring board 1 running above the spray pipe 5. One end of the spray pipe 5 is connected to a first flexible nose 8 through an L-shaped pipe 7, as shown in Figs. 2 and 3. The first flexible hose 8 in turn is connected through a valve 9 and a second flexible hose 10 to a source (not shown) for supplying a gas such as air, inert gas or the like. Therefore, a gas supplied from the supply source through the second flexible hose 10, the valve 9, the first flexible hose 8 and the L-shaped pipe 7 is blown out from the nozzle holes 6 of the spray pipe 5 toward the lower surface of the running printed wiring board 1 in the direction opposite to the running direction of the printed wiring board 1. While the printed wiring board 1 is transported from the fluxer 3 to the preheater 4, a flux coated on the lower surface of the printed wiring board 1 by the fluxer 3 is pressed to the lower surface of the printed wiring board 1 by the gas blown out from the spray pipe 5, whereby a part of the flux is forced to be introduced into through holes of the printed wiring board 1. An oxide film covering exposed conductors on the lower surface of the printed wiring board 1 and conductors in the through holes reacts with the flux and is thus removed while the printed wiring board 1 is heated by the preheater 4. As a result, when the printed wiring board 1 is transported to the solder bath T positioned downstream of the preheater 4, conductors on the printed wiring board 1, particularly those in the through holes have a sufficient wettability with respect to molten solder, whereby extremely few failed soldering will occur.

When a plurality of spray pipes are employed, the respective spray pipes may be arranged along the transporting conveyer with an equal space therebetween and at an angle perpendicular to the running direction of the printed wiring board 1.

It should be noted that a pressure of the gas blown out from the nozzle holes 6 is adjusted by manipulating the valve 9 such that the flux sufficiently penetrates into the through holes but does not reach the upper surface of the printed wiring board 1 through the through holes.

If a flux containing inflammable components is used in the fluxer 3, there is a danger of the inflammable gas generated from the fluxer 3 to enter the preheater 4. However, by the use of the spray pipe 5 arranged as described above, air or inert gas blown out from the spray pipe 5 acts to bring the inflammable gas generated from the fluxer 3 far away from the preheater 4, which results in improving the safety of the preheater 4.

In addition, it is also effective to provide a fan for sending air in the direction opposite to the running direction of the printed wiring board 1 in a manner similar to the spray pipe 5 in order to further improve the safety of the preheater 4.

According to the present invention, since constructed as described above, the following advantage is obtainable.

The wettability of the through holes in the printed circuit board with respect to molten solder is improved, thereby eliminating failed soldering of parts with lead. Also, the safety of the automatic soldering is improved by preventing the flux containing inflammable components from entering the preheater.

## Claims

1. An automatic soldering apparatus for printed wiring boards comprising:
transporting means for successively transporting the printed wiring boards with through holes to a solder bath;
a fluxer for coating a flux on said printed wiring board; and
means for blowing a gas onto a surface of said printed wiring board on which the flux has been coated by said fluxer.

2. An automatic soldering apparatus for printed wiring boards according to claim 1, wherein said gas blowing means comprises a spray pipe having a plurality of nozzle holes which are arranged so as to intersect with a transporting direction of the printed wiring boards.

3. An automatic soldering apparatus for printed wiring boards according to claim 1, wherein said gas is a fire retardant gas.

4. An automatic soldering apparatus for printed wiring boards according to claim 1, wherein said nozzle holes of said spray pipe are open in a direction opposite to the transporting direction of the printed wiring boards.
